# EUROPÄISCHE PATENTSCHRIFT

(11) **EP 2 546 670 B1**
(45) Veröffentlichungstag und Bekanntmachung des Hinweises auf die Patenterteilung: **30.11.2016**
(21) Anmeldenummer: 12004922.6
(22) Anmeldetag: 02.07.2012
(51) Int. Cl.: G01R 33/07

(54) **Hallsensor**
Hall effect sensor
Capteur Hall

(30) Priorität: 15.07.2011 DE 102011107767
(43) Veröffentlichungstag der Anmeldung: 16.01.2013
(73) Patentinhaber: Micronas GmbH, 79108 Freiburg (DE); Albert-Ludwigs-Universität Freiburg, 79104 Freiburg (DE)
(72) Erfinder: Raz, Roiy, 79106 Freiburg (DE); Kaufmann, Timo, 79183 Waldkirch-Suggental (DE); Ruther, Patrick, Dr., 76199 Karlsruhe (DE); Paul, Oliver, Prof. Dr., 79280 Au (DE)
(74) Vertreter: Koch, Bertram

(56) Entgegenhaltungen:
- DE-A1-102005 014 157
- DE-C1- 10 150 955
- US-A- 4 829 352

## Beschreibung

Die Erfindung betrifft einen Hallsensor gemäß dem Oberbegriff des Patentanspruchs 1.

Aus der DE 101 50 955 C1 ist ein Hallsensor bekannt. Der Hallsensor weist mehrere vertikale Hallelemente mit jeweils fünf Anschlusskontakten auf. Hierbei sind die bis zu vier Hallelemente parallel zueinander ausgebildet und die Anschlusskontakte mittels einer zyklischen Vertauschung miteinander verschaltet, um die Offsetspannung des Hallsensors im Vergleich zu der Offsetspannung eines einzelnen Hallelements zu verringern. Zusätzlich lässt sich die Offsetspannung mittels der sogenannten "Spinning-Current"-Methode weiter verringern. Es ist wünschenswert, die aufwändige Anordnung, den Offset und den Leistungsverbrauch der Hallsensoren zu verbessern. Aus der US 4 829 352 A und der DE 10 2005 0141 57 A1 sind weitere Hallsensoren bekannt.

Vor diesem Hintergrund besteht die Aufgabe der Erfindung darin, eine Vorrichtung anzugeben, die den Stand der Technik weiterbildet.

Die Aufgabe wird durch einen Hallsensor mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Hallsensor bereitgestellt, aufweisend ein erstes Hallelement mit einem ersten Anschlusskontakt und mit einem zweiten Anschlusskontakt und mit einem dritten Anschlusskontakt, ein zweites Hallelement mit einem vierten Anschlusskontakt und mit einem fünften Anschlusskontakt und mit einem sechsten Anschlusskontakt, ein drittes Hallelement mit einem siebten Anschlusskontakt und mit einem achten Anschlusskontakt und mit einem neunten Anschlusskontakt, ein viertes Hallelement mit einem zehnten Anschlusskontakt und mit einem elften Anschlusskontakt und mit einem zwölften Anschlusskontakt, wobei das erste Hallelement und das zweite Hallelement und das dritte Hallelement und das vierte Hallelement in Serie geschaltet sind. Es sei angemerkt, dass der Hallsensor aus vier zueinander in Reihe geschalteten Hallelementen besteht.

Hierbei weist jedes der vier Hallelemente einen mittleren Anschlusskontakt und wenigstens zwei sich um den mittleren Anschlusskontakt angeordneten Anschlusskontakte auf. Die um den mittleren Anschlusskontakt angeordnete Anschlusskontakte eines Hallelementes sind mit den um den mittleren Anschlusskontakt angeordneten Anschlusskontakten des nächsten Hallelements verschaltet. Hierbei ist es bevorzugt, mittels der Verschaltung einen geschlossenen Ring zu erzeugen, d.h. das letzte Hallelement in der Reihe ist mit dem ersten Hallelement der Reihe verschaltet. Der ausgebildete Hallsensor weist hierdurch vier Anschlusskontakte auf, wobei die vier Anschlusskontakte aus den vier mittleren Anschlusskontakte der einzelnen Hallelemente gebildet werden.

Ein Vorteil der erfindungsgemäßen Vorrichtung ist es, dass sich durch die erfindungsgemäße Verschaltung von vier einzelnen Hallelementen mit jeweils drei Kontakten die Offsetspannung des Hallsensors verringern lässt. Hierzu wird die Serienverschaltung der vier Hallelemente vorzugsweise in vier unterschiedlichen Moden nach der sogenannten "Spinning-current"-Methode betrieben und die Offsetspannungen der einzelnen Moden zu einer Gesamtoffsetspannung addiert. Untersuchungen der Anmelderin haben gezeigt, dass die Gesamtoffsetspannung wesentlich kleiner als die Offsetspannung eines einzelnen vertikalen Hallelements mit fünf Kontakten betrieben mit der "Spinning-Current"-Methode und überraschenderweise fast Null ist. Eine aufwändige Parallelschaltung von mehreren Hallsensoren erübrigt sich aufgrund dessen, dass die Offsetspannung nämlich bereits fast Null ist.

Das neue Sensorkonzept zeichnet sich dadurch aus, dass in allen vier Moden eine gleiche Kombination von Steuerstromverteilungen in den einzelnen Hallelementen erhalten wird. Bei einem einzelnen Hallelement mit fünf Kontakten ist die Steuerstromvertellung zwischen den einzelnen Moden unterschiedlich. Untersuchungen haben gezeigt, dass sich auch Hallelemente mit beispielsweise jeweils fünf Kontakten gemäß der erfindungsgemäßen Serienverschaltung verwenden lassen. Hierbei sind bevorzugt die jeweils innenliegenden drei Kontakten zu verwenden. Des Weiteren lassen sich auch Hallelemente mit 4 Kontakten, mit 6 Kontakten oder entsprechend mehr als 6 Kontakten gemäß der erfindungsgemäßen Serienschaltung verschalten.

Ein weiterer Vorteil Ist, dass die Kontakt- und Verbindungswiderstände bei der Serienschaltung von den vier Hallelementen sich symmetrisch verteilen lassen und in allen Moden nahezu gleich groß sind. Hierdurch sind die Offsetspannungen der einzelnen Moden in erster Näherung entgegengesetzt gleich groß.

Es versteht sich, dass die vier Hallelemente des Hallsensors zur Erzeugung einer Hallspannung eine stromdurchflossene Fläche aufweisen, wobei der Normalenvektor der Fläche parallel zu der Richtung der zu messenden Komponente der die Fläche durchdringenden Magnetfeldes ausgebildet ist. Des Weiteren ist die Offsetspannung vorzugsweise in der Abwesenheit eines magnetischen Feldes zu messen. Ein derartiger Messzyklus wird auch als Kalibratlon bezeichnet.

In einer weiteren Ausführungsform sind der zweite Anschlusskontakt und der fünfte Anschlusskontakt und der achte Anschlusskontakt und der elfte Anschlusskontakt jeweils als Versorgungsspannungsanschlüsse oder als Hallspannungsabgriffe ausgebildet. Hierbei ist das Vorzeichen der zu messenden Hallspannung von der Richtung des Stromflusses und der Richtung des anliegenden Magnetfeldes und der Dotierung der Halbleiterbereiche, in denen die Hallelemente ausgebildet sind, abhängig. Für die Ausbildung der Serienverschaltung ist in einer anderen Ausführungsform Ist der erste Anschlusskontakt mit dem zwölften Anschlusskontakt verbunden. In einer weiteren Ausführungsform ist der dritte Anschlusskontakt mit dem vierten Anschlusskontakt und der sechste Anschlusskontakt mit dem siebten Anschlusskontakt und der neunte Anschlusskontakt mit dem zehnten Anschlusskontakt verschaltet. Zur Veranschaulichung sind in der Tabelle 1 die vier Moden, d.h. Modus 1 bis Modus 4, zum Betreiben des Hallsensors aufgellstet. Hierbei bezeichnet die Beschriftung C1 bis C4 jeweils den mittleren Kontakt der einzelnen Hallelemente, sowie VB1, VB2, die beiden Betriebsspannungen und VH1 und VH2 die beiden Messspannungen, wobei die Differenz der beiden Messspannungen auch als Hallspannung bezeichnet wird.

**Tabelle 1:**

| | **C1** | **C2** | **C3** | **C4** |
|---|---|---|---|---|
| **Modus 1 (M1)** | VB1 | VH1 | VB2 | VH2 |
| **Modus 2 (M2)** | VB2 | VH2 | VB1 | VH1 |
| **Modus 3 (M3)** | VH2 | VB1 | VH1 | VB2 |
| **Modus 4 (M4)** | VH1 | VB2 | VH2 | VB1 |

In einer bevorzugten Ausführungsform sind bei dem ersten Hallelement bis einschließlich dem vierten Hallelement die drei Anschlusskontakte jeweils auf einer Geraden angeordnet und die Geraden sind vorzugsweise zueinander parallel angeordnet, d h. die Hallelemente sind zueinander parallel angeordnet. Gemäß einer Weiterbildung sind die Anschlusskontakte des ersten Hallelements bis einschließlich des vierten Hallelements auf einer gemeinsamen Geraden angeordnet. Insbesondere ist es bevorzugt, das erste Hallelement bis einschließlich des vierten Hallelements jeweils als vertikale Hallelemente auszubilden. Es sei angemerkt, dass es bevorzugt ist, die Leiterbahnwiderstände zur Verbindung der einzelnen Hallelemente untereinander möglichst gleich groß zu wählen.

Untersuchungen der Anmelderin haben gezeigt, dass es zweckmäßig ist, wenn das erste Hallelement und das zweite Hallelement und das dritte Hallelement und das vierte Hallelement auf einem Halbleiterkörper angeordnet sind und auf dem Halbleiterkörper eine integrierte Schaltung ausgebildet ist. Hierdurch lassen sich eine als Teil der integrierten Schaltung ausgebildete, mit dem Hallsensor in einer Wirkverbindung stehende Ansteuerschaltung, und eine Auswerteschaltung monolithisch integrieren. Es sei angemerkt, dass unter dem Begriff Wirkverbindung unter anderem auch eine elektrische Verbindung zwischen der integrierten Schaltung und dem Hallsensor verstanden wird. Weiterhin ist es bevorzugt, das erste Hallelement und das zweite Hallelement und das dritte Hallelement und das vierte Hallelement und die integrierte Schaltung in einem einzigen gemeinsamen Gehäuse anzuordnen und vorzugsweise miteinander elektrisch zu verschalten.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckungen sind nicht maßstäblich und weisen, sofern nicht anders angegeben, auch keine ableitbare geometrische Relation zueinander auf. Darin zeigen die:
- Figur 1: eine schematische Ansicht auf eine Ausführungsform einer erfindungsgemäßen Serlenverschaltung von vier Hallelementen eines Hallsensors,
- Figur 2: einen schematischen Querschnitt einer Ausführungsform eines einzelnen Hallelements der Figur 1,
- Figur 3a: eine erste geometrische Anordnungsmögllchkeit der vier Hallelemente der Figur 1,
- Figur 3b: eine zweite geometrische Anordnungsmöglichkeit der vier Hallelemente der Figur 1,
- Figur 4: eine schematische Darstellung des Zusammenhangs zwischen der Offsetspannung und einer anliegenden Versorgungsspannung für einen n-dotlerten Hallsensor in den vier Moden.

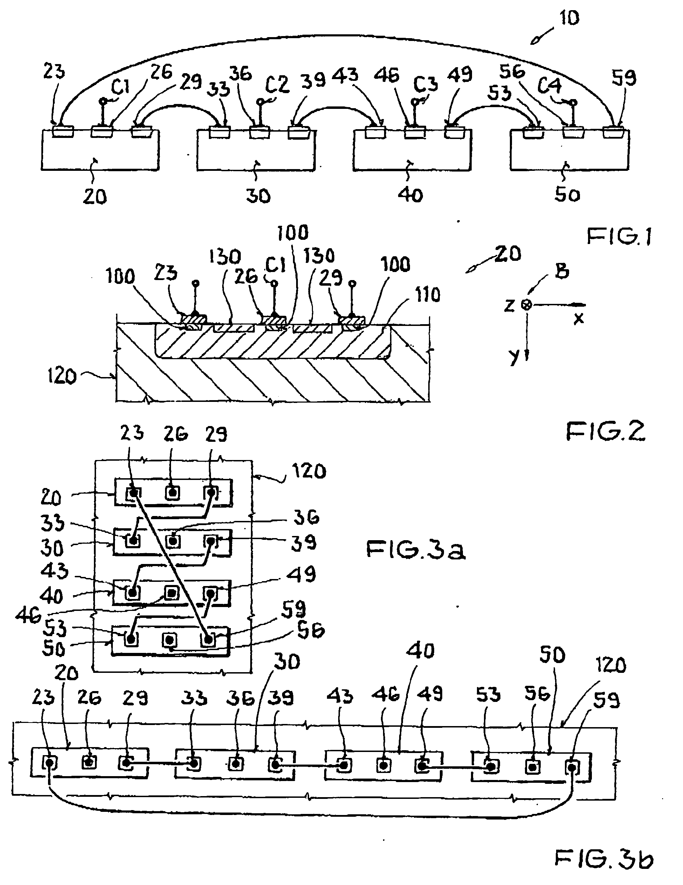

Die Abbildung der Figur 1 zeigt eine schematische Ansicht auf eine Ausführungsform einer erfindungsgemäßen Serlenverschaltung eines Hallsensors 10, aufweisend ein erstes vorzugsweise vertikal ausgebildetes Hallelement 20, mit einem ersten Anschlusskontakt 23, einem zweiten Anschlusskontakt 26 und einem dritten Anschlusskontakt 29, einem zweiten vorzugsweise vertikal ausgebildeten Hallelement 30, mit einem vierten Anschlusskontakt 33, einem fünften Anschlusskontakt 36 und einem sechsten Anschlusskontakt 39, einem dritten vorzugsweise vertikal ausgebildeten Hallelement 40, mit einem siebten Anschlusskontakt 43, einem achten Anschlusskontakt 46 und einem neunten Anschlusskontakt 49 und einem vierten vorzugsweise vertikal ausgebildeten Hallelement 50, mit einem zehnten Anschlusskontakt 53, einem elften Anschlusskontakt 56 und einem zwölften Anschlusskontakt 59. Des Weiteren ist der erste Anschlusskontakt 23 mit dem zwölften Anschlusskontakt 59 verschaltet. Je nach Modus sind gemäß der Anordnung der Tabelle 1 der zweite Anschlusskontakt 26 mit einem ersten Anschlusspunkt C1 und der fünfte Anschlusskontakt 36 mit einem zweiten Anschlusspunkt C2 und der achte Anschlusskontakt 46 mit einem dritten Anschlusspunkt C3 und der elfte Anschlusskontakt 56 mit einem vierten Anschlusspunkt C4 jeweils als Versorgungsspannungsanschlüsse oder als Hallspannungsabgriffe ausgebildet. Je nach Modus wird an den ersten bis vierten Anschlusspunkt eine Versorgungsspannung VB1 oder ein davon abweichendes Referenzpotential VB2 angelegt oder eine Hallspannung VH1 oder eine Hallspannung VH2 gemessen.

In der Figur 2 ist ein schematischer Querschnitt einer Ausführungsform eines einzelnen Hallelements am Beispiel des ersten Hallelements 20 der Figur 1 dargestellt. Im Folgenden werden nur die Unterschiede zu der Ausführungsform abgebildet in der Figur 1 erläutert. Unmittelbar unterhalb des ersten Anschlusskontaktes 23 bis einschließlich des dritten Anschlusskontaktes 29 ist ein hochdotiertes n-Kontaktgeblet 100 ausgebildet, um die einzelnen Anschlusskontakte 23 bis 29 niederohmig an ein niedrig dotiertes n-Wannengeblet 110 anzuschließen. Das n-Wannengebiet 110 ist in einem Halbleiterkörper 120 ausgebildet. Zwischen den einzelnen n-Kontaktgebieten ist jeweils ein Isolationsgebiet 130, vorzugsweise aus Oxid oder einer hochdotierten p⁺-Diffusion bestehend, ausgebildet. Der Halbleiterkörper 120 ist vorzugsweise als p-Substrat ausgebildet. Vorzugsweise weist das n-Wannengebiet eine Phosphordotierung auf und das n-Kontaktgeblet vorzugsweise eine höhere Phosphordotierung als das n-Wannengeblet auf. Demhingegen weist das p-Substrat eine Bordotierung auf.

Gemäß der dargestellten Ausführungsform in Fig. 2 weist die Richtung eines zu messenden Magnetfeldes In eine z-Richtung, d.h. in die Zeichenebene hinein oder hinaus, während das erste Hallelement 20 in der x-y Ebene ausgebildet ist.

In der Abbildung der Figur 3a ist eine erste geometrische Anordnungsmöglichkeit der vier Hallelemente der Figur 1 dargestellt. Im Folgenden werden nur die Unterschiede zu der Ausführungsform abgebildet in der Figur 1 erläutert. Bei dem ersten Hallelement 20 bis einschließlich des vierten Hallelements 50 sind jeweils die drei Anschlusskontakte auf einer Geraden - nicht eingezeichnet - angeordnet, wobei die einzelnen Geraden im Wesentlichen zueinander parallel angeordnet sind.

In der Abbildung der Figur 3b ist eine zweite geometrische Anordnungsmöglichkeit der vier Hallelemente der Figur 1 dargestellt. Im Folgenden werden nur die Unterschiede zu der Ausführungsform abgebildet In der Figur 1 erläutert. Demgemäß sind nun sämtliche Anschlusskontakte des ersten Hallelements bis einschließlich des vierten Hallelements auf einer gemeinsamen Geraden - nicht eingezeichnet - angeordnet.

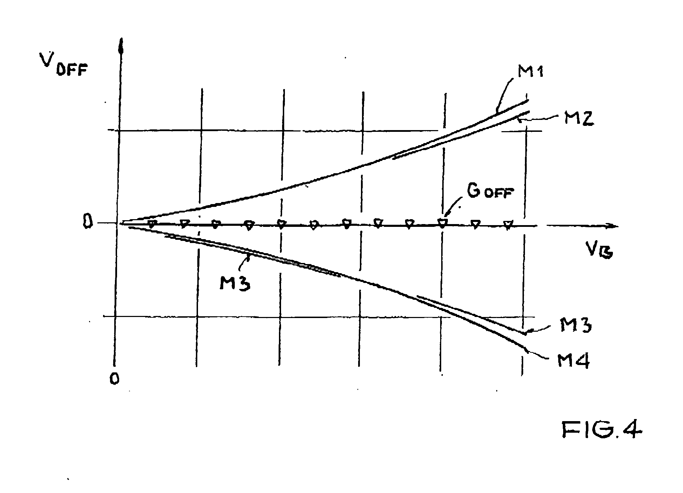

In der Abbildung der Figur 4 ist eine schematische Darstellung des Zusammenhangs zwischen einer Offsetspannung VOFF=VH1-VH2 ohne Einfluss eines Magnetfeldes und einer anliegenden Versorgungsspannung VB=VB1-VB2 für einen n-dotierten Hallsensor dargestellt. Es sei angemerkt, dass es vorteilhaft ist, die Offsetspannung während einer sogenannten Kalibrationsphase unter Abwesenheit eines Magnetfeldes zu bestimmen. Gemäß einer alternatlven Vorgehensweise lässt sich die Offsetspannung mittels der sogenannten "Spinning-Current"-Methode weitestgehend unabhängig von einem Magnetfeld eliminieren. Hierdurch Ist das resultierende Messsignal, d. h. die Hallspannung bereits weitestgehend vorzugsweise vollständig frei von der Offsetspannung. Es zeigt sich, dass die gemessene Offsetspannung VOFF in einem ersten Modus M1 oder einem zweiten Modus M2 oder einem dritten Modus M3 oder einem vierten Modus M4 positiv oder negativ Ist und nach der Addition der Offsetspannungen der einzelnen Moden, die aus einer Mittelwertsbildung berechnete Gesamtoffsetspannung GOFF, dargestellt mit dreieckförmigen Symbole, nahezu eine Gerade mit der Steigung Null ausbildet.

## Patentansprüche

1. Hallsensor (10) aufweisend,
- ein erstes Hallelement (20) mit einem ersten Anschlusskontakt (23) und mit einem zweiten Anschlusskontakt (26) und mit einem dritten Anschlusskontakt (29)
- ein zweites Hallelement (30) mit einem vierten Anschlusskontakt (33) und mit einem fünften Anschlusskontakt (36) und mit einem sechsten Anschlusskontakt (39)
- ein drittes Hallelement (40) mit einem siebten Anschlusskontakt (43) und mit einem achten Anschlusskontakt (46) und mit einem neunten Anschlusskontakt (49)
- ein viertes Hallelement (50) mit einem zehnten Anschlusskontakt (53) und mit einem elften Anschlusskontakt (56) und mit einem zwölften Anschlusskontakt (59),
- jedes der vier Hallelemente zwei um einen mittleren Anschlusskontakt angeordneten Anschlusskontakte aufweist, und die um den mittleren Anschlusskontakt angeordneten Anschlusskontakte mit den um den mittleren Anschlusskontakt angeordneten Anschlusskontakte der nächsten Hallelemente verschaltet sind, so dass
das erste Hallelement (20) und das zweite Hallelement (30) und das dritte Hallelement (40) und das vierte Hallelement (50) in Serie geschaltet sind, **dadurch gekennzeichnet, dass**
bei jedem der vier Hallelement der mittlere Kontakt nicht mit den zwei um den mittleren Anschlusskontakt angeordneten Anschlusskontakte verbunden ist und der erste Anschlusskontakt (23) direkt mit dem zwölften Anschlusskontakt (59) verbunden ist.

2. Hallsensor (10) nach Anspruch 1, **dadurch gekennzeichnet, dass** der zweite Anschlusskontakt (26) und der fünfte Anschlusskontakt (36) und der achte Anschlusskontakt (46) und der elfte Anschlusskontakt (56) jeweils als Versorgungsspannungsanschlüsse oder als Hallspannungsabgriffe ausgebildet sind.

3. Hallsensor (10) nach Anspruch 1 oder Anspruch 2, **dadurch gekennzeichnet, dass** jedes der Hallelemente (20, 30, 40, 50) in einem n-Wannengebiet ausgebildet ist und zwischen den n-Wannengebieten (110) der Hallelemente (20, 30, 40, 50) ein p-Substrat des Halbleiterkörpers (120) ausgebildet ist.

4. Hallsensor (10) nach einem der vorstehenden Ansprüche, **dadurch gekennzeichnet, dass** der dritte Anschlusskontakt (29) mit dem vierten Anschlusskontakt (33) und der sechste Anschlusskontakt (39) mit dem siebten Anschlusskontakt (43) und der neunte Anschlusskontakt (49) mit dem zehnten Anschlusskontakt (53) verschaltet ist.

5. Hallsensor (10) nach einem der vorstehenden Ansprüche, **dadurch gekennzeichnet, dass** bei dem ersten Hallelement (20) bis einschließlich dem vierten Hallelement (50) die drei Anschlusskontakte jeweils auf einer Geraden angeordnet sind und die Geraden vorzugsweise zueinander parallel angeordnet sind.

6. Hallsensor (10) nach einem der vorstehenden Ansprüche, **dadurch gekennzeichnet, dass** die Anschlusskontakte des ersten Hallelements (20) bis einschließlich des vierten Hallelements (50) auf einer gemeinsamen Geraden angeordnet sind.

7. Hallsensor (10) nach einem der vorstehenden Ansprüche, **dadurch gekennzeichnet, dass** das erste Hallelement (20) bis einschließlich des vierten Hallelements (50) in einem Halbleiterkörper (120) jeweils als vertikale Hallelemente ausgebildet sind.

8. Hallsensor (10) nach Anspruch 7, **dadurch gekennzeichnet, dass** auf dem Halbleiterkörper (120) eine integrierte Schaltung ausgebildet ist.

9. Hallsensor (10) nach einem Anspruch 8, **dadurch gekennzeichnet, dass** das erste Hallelement (20) und das zweite Hallelement (30) und das dritte Hallelement (40) und das vierte Hallelement (50) und die integrierte Schaltung elektrisch verbunden sind und in einem einzigen gemeinsamen Gehäuse angeordnet sind.

10. Hallsensor (10) nach einem der vorstehenden Ansprüche, **dadurch gekennzeichnet, dass** jedes der Hallelemente (20, 30, 40, 50) in einem n-Wannengebiet ausgebildet ist und zwischen den n-Wannengebieten (110) der Hallelemente (20, 30, 40, 50) ein p-Substrat des Halbleiterkörpers (120) ausgebildet ist.

## Claims

1. Hall sensor (10) comprising:
- a first Hall element (20) with a first terminal contact (23), a second terminal contact (26) and a third terminal contact (29),
- a second Hall element (30) with a fourth terminal contact (33), a fifth terminal contact (36) and a sixth terminal contact (39),
- a third Hall element (40) with a seventh terminal contact (43), an eighth terminal contact (46) and a ninth terminal contact (49) and
- a fourth Hall element 950) with a tenth terminal contact (53), an eleventh terminal contact (56) and a twelfth terminal contact (59),
- each of the four Hall elements comprising two terminal contacts arranged around a middle terminal contact and the terminal contacts arranged around the middle terminal contact being connected with the terminal contacts, which are arranged the middle terminal contact, of the next Hall elements so that the first Hall element (20), the second Hall element (30), the third Hall element (40) and the fourth Hall element (50) are connected in a series,
**characterised in that**
in each of the four Hall elements the middle contact is not connected with the two terminal contacts arranged around the middle terminal contact, and the first terminal contact (23) is directly connected with the twelfth terminal contact (59).

2. Hall sensor (10) according to claim 1, **characterised in that** the second terminal contact (26), the fifth terminal contact (36), the eighth terminal contact (46) and the eleventh terminal contact (56) are respectively constructed as supply voltage terminals or as Hall voltage taps.

3. Hall sensor (10) according to claim 1 or claim 2, **characterised in that** each of the Hall elements (20, 30, 40, 50) is formed in an n trough region and a p substrate of the semiconductor body (120) is formed between the n trough regions (110) of the Hall elements (20, 30, 40, 50).

4. Hall sensor (10) according to any one of the preceding claims, **characterised in that** the third terminal contact (29) is connected with the fourth terminal contact (33), the sixth terminal contact (39) is connected with the seventh terminal contact (43) and the ninth terminal contact (49) is connected with the tenth terminal contact (53).

5. Hall sensor (10) according to any one of the preceding claims, **characterised in that** in the case of the first Hall element (20) to the fourth Hall element (50) inclusive the three terminal contacts are respectively arranged on a straight line and the straight lines are preferably arranged parallel to one another.

6. Hall sensor (10) according to any one of the preceding claims, **characterised in that** the terminal contacts of the first Hall element (20) to the fourth Hall element (50) inclusive are arranged on a common straight line.

7. Hall sensor (10) according to any one of the preceding claims, **characterised in that** the first Hall element (20) to the fourth Hall element (50) inclusive are arranged in a semiconductor (120) as respective vertical Hall elements.

8. Hall sensor (10) according to claim 7, **characterised in that** an integrated circuit is formed on the semiconductor body (120).

9. Hall sensor (10) according to claim 8, **characterised in that** the first Hall element (20), the second Hall element (30), the third Hall element (40), the fourth Hall element (50) and the integrated circuit are electrically connected and are arranged in a single common housing.

10. Hall sensor (10) according to any one of the preceding claims, **characterised in that** each of the Hall elements (20, 30, 40, 50) is formed in an n trough region and a p substrate of the semiconductor body (120) is formed between the n trough regions (110) of the Hall elements (20, 30, 40, 50).

## Revendications

1. Capteur de Hall (10), présentant
- un premier élément de Hall (20) avec un premier contact de raccordement (23) et avec un deuxième contact de raccordement (26) et avec un troisième contact de raccordement (29),
- un deuxième élément de Hall (30) avec un quatrième contact de raccordement (33) et avec un cinquième contact de raccordement (36) et avec un sixième contact de raccordement (39),
- un troisième élément de Hall (40) avec un septième contact de raccordement (43) et avec un huitième contact de raccordement (46) et avec un neuvième contact de raccordement (49),
- un quatrième élément de Hall (50) avec un dixième contact de raccordement (53) et avec un onzième contact de raccordement (56) et avec un douzième contact de raccordement (59),
- chacun des quatre éléments de Hall présente deux contacts de raccordement disposés autour d'un contact de raccordement central, et les contacts de raccordement disposés autour du contact de raccordement central sont connectés aux contacts de raccordement disposés autour du contact de raccordement central des éléments de Hall suivants, de telle manière que le premier élément de Hall (20) et le deuxième élément de Hall (30) et le troisième élément de Hall (40) et le quatrième élément de Hall (50) soient montés en série,
**caractérisé en ce que**, dans chacun des quatre éléments de Hall, le contact central n'est pas relié aux deux contacts de raccordement disposés autour du contact de raccordement central et le premier contact de raccordement (23) est relié directement au douzième contact de raccordement (59).

2. Capteur de Hall (10) selon la revendication 1, **caractérisé en ce que** le deuxième contact de raccordement (26) et le cinquième contact de raccordement (36) et le huitième contact de raccordement (46) et le onzième contact de raccordement (56) sont réalisés respectivement en tant que raccords de tension d'alimentation ou en tant que prises de tension de Hall.

3. Capteur de Hall (10) selon la revendication 1 ou la revendication 2, **caractérisé en ce que** chacun des éléments de Hall (20, 30, 40, 50) est formé dans une région de cuvette n et un substrat p du corps semi-conducteur (120) est formé entre les régions de cuvette n (110) des éléments de Hall (20, 30, 40, 50).

4. Capteur de Hall (10) selon l'une quelconque des revendications précédentes, **caractérisé en ce que** le troisième contact de raccordement (29) est connecté au quatrième contact de raccordement (33) et le sixième contact de raccordement (39) est connecté au septième contact de raccordement (43) et le neuvième contact de raccordement (49) est connecté au dixième contact de raccordement (53).

5. Capteur de Hall (10) selon l'une quelconque des revendications précédentes, **caractérisé en ce que**, dans le premier élément de Hall (20) jusqu'au quatrième élément de Hall (50) inclus, les trois contacts de raccordement sont disposés respectivement sur une droite et les droites sont disposées de préférence parallèlement l'une à l'autre.

6. Capteur de Hall (10) selon l'une quelconque des revendications précédentes, **caractérisé en ce que** les contacts de raccordement du premier élément de Hall (20) jusqu'au quatrième élément de Hall (50) inclus sont disposés sur une droite commune.

7. Capteur de Hall (10) selon l'une quelconque des revendications précédentes, **caractérisé en ce que** le premier élément de Hall (20) jusqu'au quatrième élément de Hall (50) inclus sont formés dans un corps semi-conducteur (120) chaque fois en tant qu'éléments de Hall verticaux.

8. Capteur de Hall (10) selon la revendication 7, **caractérisé en ce qu'**un circuit intégré est formé sur le corps semi-conducteur (120).

9. Capteur de Hall (10) selon la revendication 8, **caractérisé en ce que** le premier élément de Hall (20) et le deuxième élément de Hall (30) et le troisième élément de Hall (40) et le quatrième élément de Hall (50) et le circuit intégré sont reliés électriquement et sont disposés dans un boîtier unique commun.

10. Capteur de Hall (10) selon l'une quelconque des revendications précédentes, **caractérisé en ce que** chacun des éléments de Hall (20, 30, 40, 50) est formé dans une région de cuvette n et un substrat p du corps semi-conducteur (120) est formé entre les régions de cuvette n (110) des éléments de Hall (20, 30, 40, 50).
